(19)

Europäisches
Patentamt
European
Patent Office
Office européen
des brevets

(11)　**EP 1 911 552 A1**

(12)　**EUROPEAN PATENT APPLICATION**
published in accordance with Art. 153(4) EPC

(43) Date of publication:
**16.04.2008　Bulletin 2008/16**

(21) Application number: **06767644.5**

(22) Date of filing: **29.06.2006**

(51) Int Cl.:
**B25J 9/22** (2006.01)　　　**B25J 19/06** (2006.01)
**B65G 49/07** (2006.01)

(86) International application number:
**PCT/JP2006/313027**

(87) International publication number:
**WO 2007/010725 (25.01.2007 Gazette 2007/04)**

(84) Designated Contracting States:
**DE FR**

(30) Priority:　**15.07.2005　JP　2005206304**

(71) Applicant: **KABUSHIKI KAISHA YASKAWA DENKI**
**Kitakyushu-Shi,**
**Fukuoka 806-0004 (JP)**

(72) Inventors:
　• **ADACHI, Masaru,**
　　**c/o K.K. YASKAWA DENKI**
　　**Kitakyushu-shi,**
　　**Fukuoka 806-0004 (JP)**

• **KAWABE, Mitsunori,**
　**c/o K.K. YASKAWA DENKI**
　**Kitakyushu-shi,**
　**Fukuoka 806-0004 (JP)**

(74) Representative: **Grünecker, Kinkeldey,**
**Stockmair & Schwanhäusser**
**Anwaltssozietät**
**Maximilianstrasse 58**
**80538 München (DE)**

(54)　**WAFER POSITION TEACHING METHOD AND TEACHING TOOL**

(57)　To provide a method which can automatically teach the position of a wafer accurately without causing interference even in the case where a processing apparatus has a small inlet opening and to provide an external teaching jig for the method.

The wafer position teaching method for a wafer transporting apparatus is arranged in a manner that as to a robot for transporting a semiconductor wafer between a housing chamber and a processing apparatus or between the processing apparatuses, a teaching jig (16) is disposed at a position where the semiconductor wafer is disposed in the housing chamber or the processing apparatus, the teaching jig is detected by a sensor provided at the wafer gripper of the robot thereby to teach the position of the semiconductor wafer to the robot. To be concrete, before detecting the teaching jig (16) by the sensor, the sensor detects external teaching jigs (17) disposed at the front side outer wall of the processing apparatus to roughly estimate the position of the teaching jig. Then, the sensor approaches and detects the teaching jig based on the estimated position thereby to obtain the position of the semiconductor wafer.

FIG. 7

EP 1 911 552 A1

**Description**

Technical Field

The present invention relates a method for teaching the position of a semiconductor wafer to a robot for transporting a semiconductor wafer and, in particular, relates to an external teaching jig.

Background Art

Conventionally, like a general industrial robot, a teaching operation of the semiconductor wafer transporting robot is performed in a manner that an operator observes a wafer to be transported thereby to confirm the position thereof and then guides the robot to the wafer. However, there arise a case that it is difficult or impossible to observe a wafer inside a processing apparatus and the like. Thus, a so-called auto-teaching method or apparatus has been proposed in which a teaching jig having the same size as an actual wafer is placed on a processing apparatus and the like. In place of the wafer, a sensor provided at the end effect on the robot detects the position of the teaching jig thereby to teach the position to the robot.
Inventors of the present application proposed a method and apparatus for sensing a teaching jig by using a hand having two light-transmission type sensors (see a patent document 1, for example). In the conventional wafer teaching method, an operation for automatically moving a wafer gripper to a position near the teaching jig to detect the teaching jig by the sensor of the wafer gripper of the robot is performed based on a teaching position (hereinafter called as a beforehand teaching position) calculated from the drawing of the apparatus in advance. Further, the inventors of the present application also proposed a method of manually moving the wafer gripper to the position near the teaching jig (see a patent document 2, for example) . However, the movement of the wafer gripper is desired to be performed automatically also in order to raise the automation rate and shorten a time required for the teaching operation.
Patent Document 1: WO03/22534
Patent Document 2: JP-A-2005-123261

Disclosure of the Invention

Problems that the Invention is to Solve

However, according to the conventional methods, in the case where the installation accuracy of the processing apparatus with respect to the robot is low, when the opening portion of the inlet (hereinafter called an inlet opening)of the apparatus is small, there arises a problem that the wafer gripper may be bumped against the apparatus at the time of approaching the wafer gripper to the teaching jig.
Thus, the invention is made in view of the above problem and an object of the invention is to provide a method which can, by detecting an external teaching jig disposed on the outer wall at the front face of an apparatus thereby to correct a teaching position in advance, automatically teach the position of a semiconductor wafer accurately without causing the interference between a wafer gripper and the apparatus even in the apparatus having a small inlet opening. Further, an object of the invention is to provide an external teaching jig and an installation method thereof which does not narrow the movable range of a robot in the normal wafer transporting process by the installation of the external teaching jig.

Means for Solving the Problems

In order to solve the aforesaid problem, the invention is arranged in the following manner.
According to a first aspect of the invention, A wafer position teaching method for teaching a position of a semiconductor wafer to a robot that transports the semiconductor wafer between a housing chamber and a processing apparatus or between the processing apparatuses, the method comprising, disposing a teaching jig at a position where the semiconductor wafer is disposed in the housing chamber or the processing apparatus, detecting the teaching jig by a sensor provided at a wafer gripper of the robot, detecting an external teaching jigs disposed at a front side outer wall of the processing apparatus to roughly estimate a position of the teaching jig by the sensor before detecting the teaching jig by the sensor, approaching by the sensor to the teaching jig based on the estimated position, and determining the position of the semiconductor wafer by sensing, wherein the external teaching jigs comprise at least two external teaching jigs, and the external teaching jigs are offset in a horizontal direction on the front side outer wall of the processing apparatus.
According to a second aspect of the invention, A teaching jig apparatus for teaching a position of a semiconductor wafer to a robot that transports the semiconductor wafer between a housing chamber and the processing apparatus or between the processing apparatuses, the teaching jig apparatus comprising, external teaching jigs for performing preliminary detection, and a teaching jig provided inside the processing apparatus, wherein the external teaching jig comprise at least two external teaching jigs, and the external teaching jigs are offset in a horizontal direction on a front side outer wall of the processing apparatus.

Effects of the Invention

According to the aspect of the invention, since the at least two external teaching jigs offset in the horizontal direction are detected, the inclination of the processing apparatus with respect to the robot can be detected and so advantageously the position of the semiconductor wafer can be estimated accurately.

Further, the position of the teaching jig is estimated by detecting the external teaching jigs provided at the front side outerwall of the apparatus, and then the beforehand teaching position calculated from the apparatus drawing held in a controller is replaced by the estimated position. The robot approaches the teaching jig based on the beforehand teaching position thus corrected, so that the wafer gripper can be guided to the teaching jig without being interfered with the apparatus. When the wafer gripper can approach the teaching jig once, the position of the semiconductor wafer can be taught to the robot even in the apparatus having a small inlet opening, advantageously.

Brief Description of the Drawings

[Fig. 1] A plan view showing the running operation of a robot using the invention.
[Fig. 2] A plan view showing the turning operation of the robot using the invention.
[Fig. 3] A plan view showing the expansion and contraction operation of the robot using the invention.
[Fig. 4] Aside elevation view showing the elevational operation of the robot using the invention.
[Fig. 5] A perspective view showing a transmission type sensor in Fig. 1.
[Fig. 6] A plan view showing a wafer transporting apparatus according to the invention.
[Fig. 7] An explanatory diagram showing the attachment state of an external teaching jig according to the invention.
[Fig. 8] A flowchart showing the operation of the invention.
[Fig. 9] A flowchart showing the continuation of Fig. 8.
[Fig. 10] An explanatory diagram showing the teaching position estimating method according to the invention.

Explanation of Symbols

| 1 | robot |
| 2 | pillar portion |
| 3 | first arm |
| 4 | second arm |
| 5 | wafer gripper |
| 6 | transmission type sensor |
| 7 | robot rotation center |
| 8 | light emitting portion |
| 9 | light receiving portion |
| 10 | optical axis |
| 11, 12, 13 | housing chamber |
| 14, 15 | processing apparatus |
| 16 | teaching jig |
| 17, 23 | external teaching jig |
| 18 | movable range in minimum rotation posture |
| 19 | front side outer wall of processing apparatus |
| 20 | inlet opening of processing apparatus |
| 21 | running axis unit |
| 22 | movable stand |
| 24 | estimated teaching position |
| 25 | wafer transporting surface |
| 26 | fixed pin |

Best Mode for Carrying Out the Invention

Hereinafter, a concrete embodiment according to a method of the invention will be explained with reference to the drawings.

(First Embodiment)

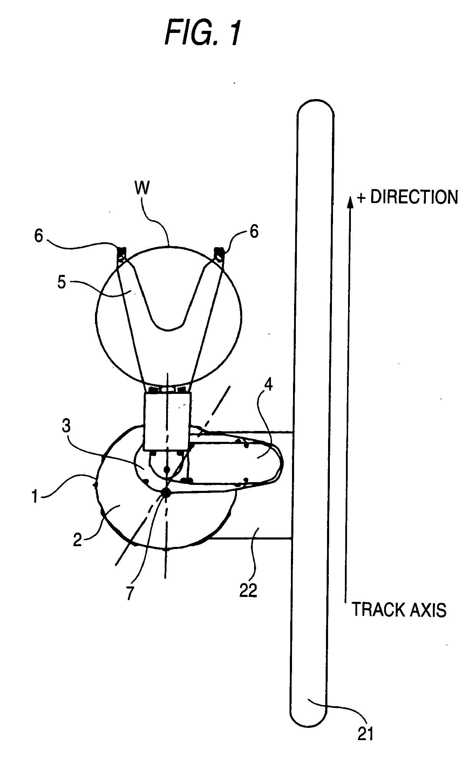

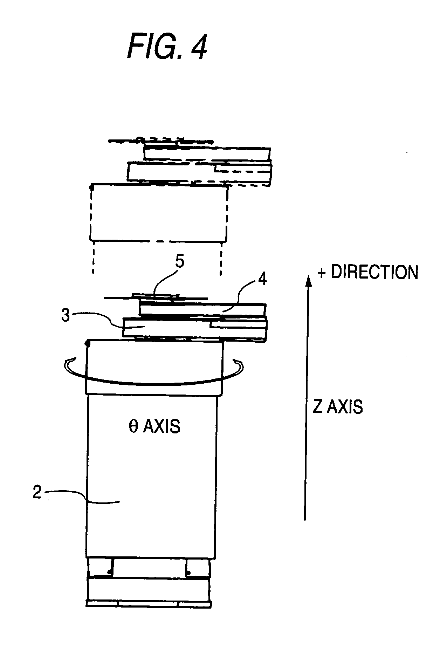

Fig. 1 is a plan view of a robot showing the embodiment of the invention and Fig. 4 is a side view thereof. In these figures, reference numeral 1 denotes a horizontal multi-jointed robot for transporting a semiconductor wafer, and reference sign W denotes the semiconductor wafer to be transported by the robot 1. The robot 1 includes a first arm 3 which rotates within the horizontal plane around the robot rotation center axis 7 of a cylindrical pillar portion 2 freely movable elevationally, a second arm 4 attached to the tip end of the first arm 3 so as to be rotatable freely within the horizontal plane, and a wafer gripper 5 attached to the tip end of the second arm 4 so as to be rotatable freely within the horizontal plane. The wafer gripper 5 is configured by a Y-shaped hand for mounting the semiconductor wafer W and includes a pair of transmission type sensors 6 at the Y-shaped tip ends thereof. Reference numeral 21 denotes a running axis unit and reference numeral 22 denotes a running axis robot stand. The robot 1 is fixed to the running axis robot stand 22.

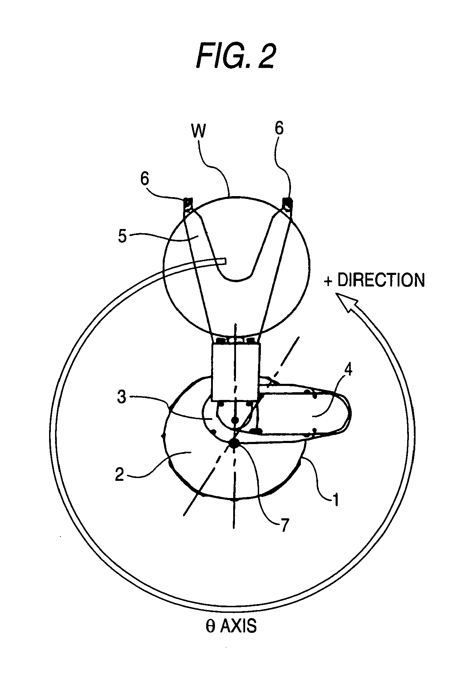

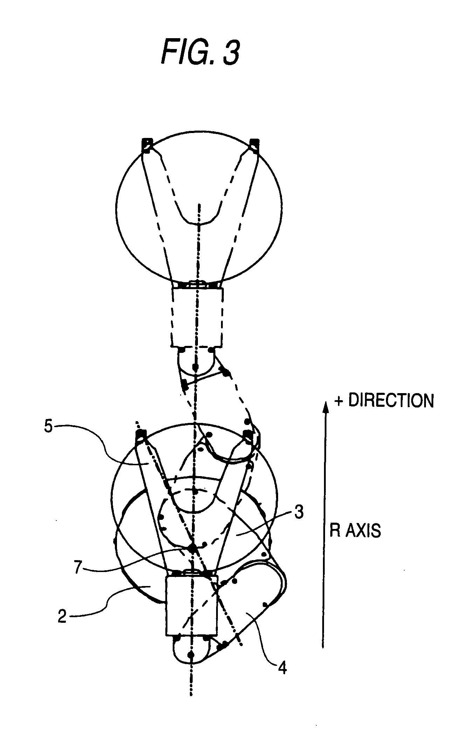

The robot 1 has four degree of freedom as explained below. That is, As shown in a plan view of Fig. 2, the robot can perform a θ-axis operation (rotation) for rotating the first arm 3 around the center axis 7 of the pillar portion 2 while maintaining the relative angles among the first arm 3, the second arm 4 and the wafer gripper 5. As shown in a plan view of Fig. 3, an R-axis operation (expansion and contraction) for expanding and contracting the wafer gripper 5 in the radial directions of the pillar portion 2 by rotating the first arm 3, the second arm 4 and the wafer gripper 5 while maintaining a constant speed ratio thereamong. As shown in Fig. 4, aZ-axis operation (elevating) for elevationally moving the pillar portion 2. As shown in Fig. 1, a T-axis operation (running) in which the robot 1 itself performs a running operation by the linear movement of the running axis unit 21.

The θ-axis is set in a manner that the counterclockwise direction is a plus direction (see Fig. 2). The R-axis is set in a manner that a direction for separating the wafer gripper 5 from the pillar portion 2, that is, a direction for extending the arm is a plus direction (see Fig. 3). The Z-axis is set in a manner that a direction for moving the pillar portion 2 upward is a plus direction (see Fig. 4). The T- axis is set in a manner that a direction for running the robot upward in the drawing is a plus direction (see Fig. 1).

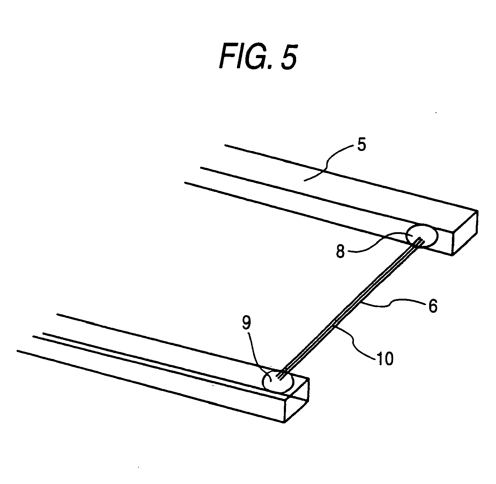

Fig. 5 is a perspective view showing the detailed configuration of the wafer gripper 5. In the figure, reference numeral 8 denotes a light emitting portion attached to the one end of the Y-shaped wafer gripper 5, and reference numeral 9 denotes a light receiving portion attached to the other end so as to oppose to the light emitting portion 8. The light emitting portion 8 and the light receiving portion 9 constitute the transmission type sensor 6. Reference numeral 10 denotes an optical axis directed to the light receiving portion 9 from the light emitting portion 8. The transmission type sensor 6 can detects a subject which interrupts the optical axis 10.

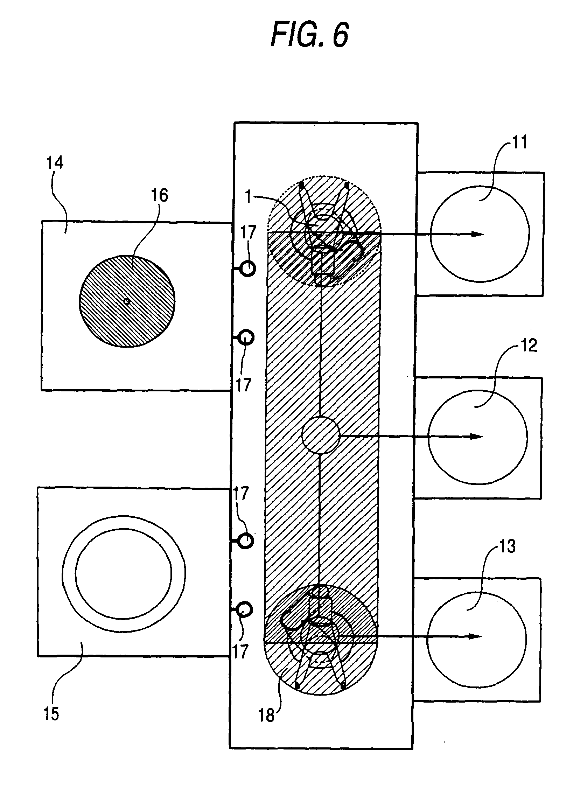

Fig. 6 is a plan view showing the entire arrangement of the wafer transporting apparatus according to the invention.

In the figure, reference numeral 14 and 15 denote a processing apparatus, reference numeral 11, 12 and 13 denote a housing chamber, reference numeral 16 denotes a teaching jig, reference numeral 17 denotes an external teaching jig, and reference numeral 18 denotes the movable range of the robot 1 in the minimum rotation posture. The two external teaching jigs 17 are disposed at each of the processing apparatuses 14, 15. The external teaching jig 17 is disposed outside of the movable range 18 in the minimum rotation posture of the robot 1. Thus, even when the external teaching jigs 17 are remained being disposed, the robot 1 can move along the running axis as usual without interfering with the external teaching jigs 17 in the minimum rotation posture. Further, when the external teaching jigs 17 are configured so as to be removable, of course, the conventional movable range of the robot 1 can be secured. Further, in this embodiment, the external teaching jig 17 is not disposed at the front side outer wall of the housing vessel because the inlet opening of the housing vessel is sufficiently large.

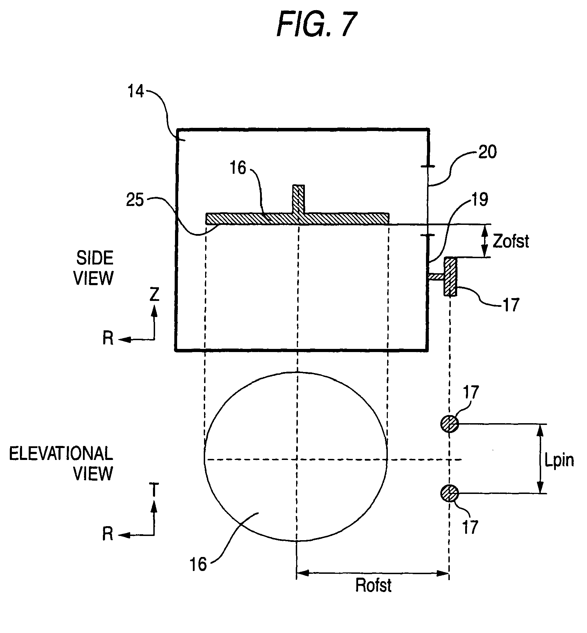

Fig. 7 is a side view and an elevational view of the apparatus in which the two external teaching jigs 17 are attached to the processing apparatus 14. In the figure, reference numeral 25 denotes a wafer transporting surface, reference numeral 19 denotes the front side outer wall of the processing apparatus, reference numeral 20 denotes the inlet opening of the apparatus, Zofst represents a distance between a wafer transporting surface 25 and an upper surface of the external teaching jig 17, and Rofst represents a distance between a center of the teaching position and a center of the external teaching jig 17 in the drawing.

The two external teaching jigs 17 are disposed at the front side outer wall of the processing apparatus in a manner that the circumferential center of each of these jigs is disposed at a position being offset by a distance Lpin/2 in the horizontal direction from the front face of the center of the teaching jig 16 inside the processing apparatus 14. That is, the distance between the two external teaching jigs 17 is Lpin. Since Lpin is known when the attachment positions of the external teaching jigs 17 are designed like Zofst and Rofst, this value is set to a controller in advance. Since the relative positions of the two external teaching jigs 17 with respect to the teaching jig 16 are determined in this manner, it is possible to estimate the position of the teaching jig 16 when the positions of the two external teaching jigs 17 are obtained.

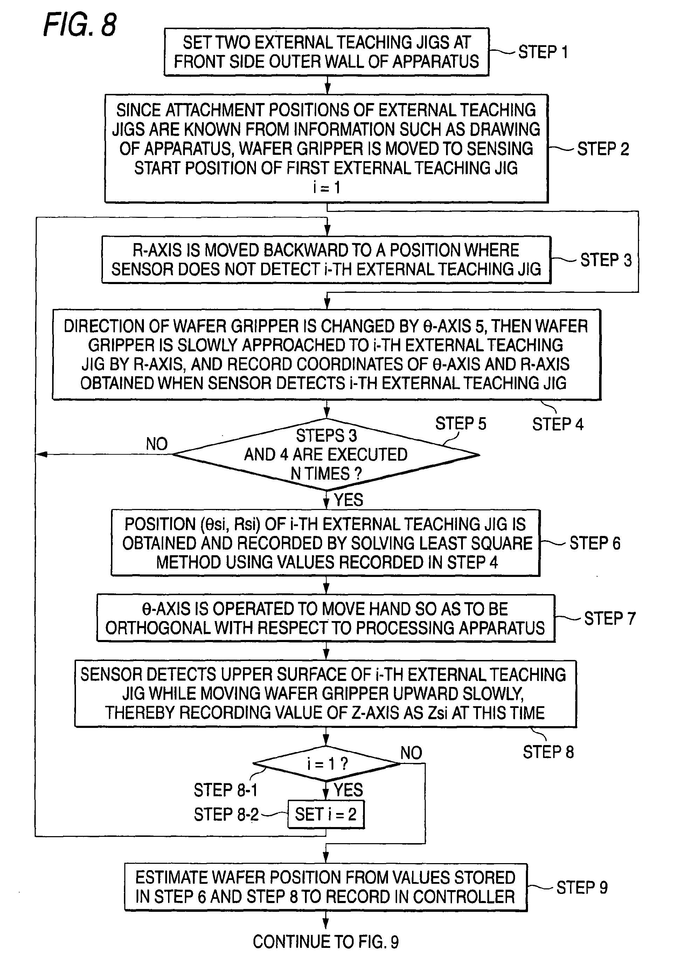

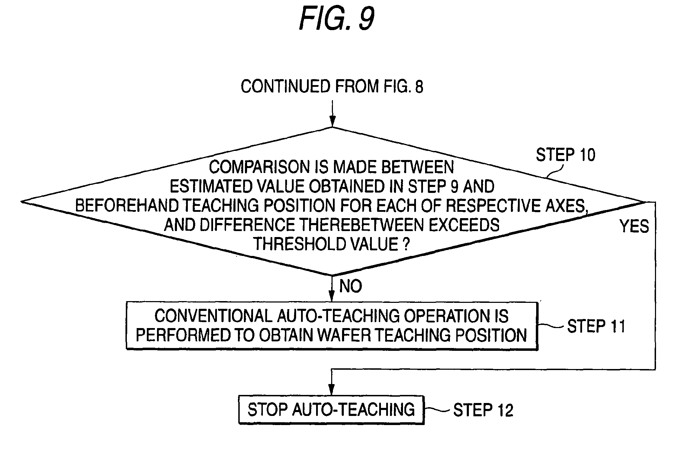

Figs. 8 and 9 are flowcharts showing the method for detecting the positions of the two external teaching jigs 17 according to the invention. Hereinafter, the position detection method will be explained in accordance with respective steps.

(Step 1) The two external teaching jigs 17 are disposed at the front side outer wall 19 of the processing apparatus.

(Step 2) Since the attachment positions of the external teaching jigs 17 are known from the information such as the drawing of the apparatus, the wafer gripper 5 can be automatically moved to the sensing start position of the first external teaching jig 17. The process transits to step 4 without executing step 3. Further, a variable i is set to 1.

(Step 3) The R-axis of the robot is moved backward to a position where the transmission type sensor 6 does not detect the i-th external teaching jig 17.

(Step 4) The $\theta$-axis is operated to change the direction of the wafer gripper 5. Then the R-axis is operated to forwardly move the wafer gripper 5 thereby to slowly approach the wafer gripper to the i-th external teaching jig 17. Then, the coordinates of the $\theta$-axis andR-axis obtainedwhen the transmission type sensor 6 detects the i-th external teaching jig 17 for the first time (that is, when the optical axis 10 contacts with the circumference of the external teaching jig 17) are recorded.

(Step 5) When steps 3 and 4 are executed for N times, the process transits to step 6. If not, the process returns to step 3. N is an arbitrary value equal to 3 or more.

(Step 6) Steps 3 and 4 are executed for N times to approach the wafer gripper 5 to the i-th external teaching jig 17 fromdifferent directions thereby to obtain a plurality of the coordinates of the $\theta$-axis and R-axis when the optical axis 10 contacts with the circumference of the i-th external teaching jig 17. The center position ($\theta_{si}$, $R_{si}$) of the i-th external teaching jig 17 is obtained and recorded by solving the least square method using these obtained values. This solving method is described in detail in the patent document 1.

(Step 7) The $\theta$-axis is operated to move the wafer gripper 5 so as to be orthogonal with respect to the processing apparatus 14. Further, the R-axis is moved forwardly by about 10 mm to place in a state where the transmission type sensor 6 can surely detect the i-th external teaching jig 17 even if the Z-axis is operated.

(Step 8) While slowly moving the wafer gripper 5 upward by operating the Z-axis, the value of the Z-axis is recorded as $Z_{si}$ when the transmission type sensor 6 does not detect the upper surface of the i-th external teaching jig 17 (that is, the optical axis 10 exceeds the upper surface of the external teaching jig 17).

(Step 8-1) The process proceeds to step 8-2 if i =1. If not, the process transits to step 9.

(Step 8-2) The process transits to step 3 after setting i =2.

(Step 9) The wafer teaching position inside the processing apparatus 14 is obtained by using the values recorded in step 6 and step 8 and Rofst, Zofst, Lpin set in the controller in advance. The method of obtaining the position will be explained in detail later. The wafer teaching position thus estimated is stored separately from the beforehand teaching position held in the controller in advance. The teaching position set in the controller in advance is supposed to be Pos1 ($\theta_1$, $R_1$, $Z_1$, $T_1$) and the estimated teaching position 24 thus obtained by using the sensor is supposed to be Pos2 ($\theta_2$, $R_2$, $Z_2$, $T_2$).

(Step 10) Pos1 and Pos2 are compared as to each of the respective axes, and if the difference therebetween as to one of the respective axes exceeds the corresponding one of threshold values Thold ($\theta_t$, $R_t$, $Z_t$, $T_t$) provided for the respective axes, the auto-teaching operation is stopped and the process transits to step 12. This means that the installation position of the processing apparatus 14 on the drawing differs largely from the actually installed position and so it is necessary to confirm the installation state of the apparatus before performing the auto-teaching.

(Step 11) Pos1 obtained in step 9 is overwritten as the beforehand teaching position of the controller to perform the conventional auto-teaching operation. When the conventional auto-teaching operation is completed normally, the teaching position of the processing apparatus 14 can be obtained correctly.

(Step 12) The arm of the robot 1 is folded up so as to be in the minimum rotation posture thereby to complete the auto-teaching operation.

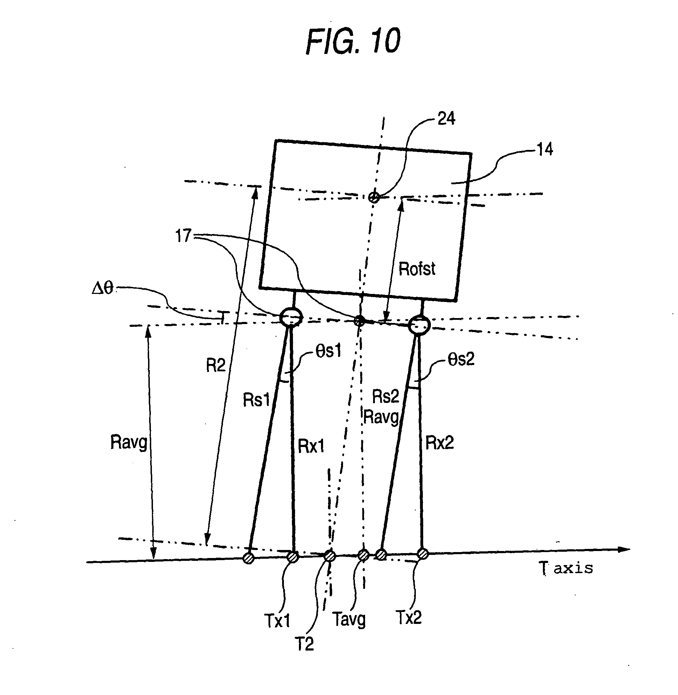

Fig. 10 is a diagram for explaining the method of estimating the wafer position according to the invention. With reference to this figure, the explanation will be made as to a method of estimating the position of the teaching jig 16 inside the processing apparatus from the estimated positions of the two external teaching jigs 17. In the figure, $R_{xi}$ can be calculated from ($\theta_{si}$, $R_{si}$) obtained in step 6 and represents the distance from the track axis to the center of the i-th external teaching jig 17. An average value of $R_{x1}$ and $R_{x2}$ is supposed to be $R_{avg}$ (expression (1)). $T_{xi}$ can be calculated from ($\theta_{si}$, $R_{si}$) obtained in step 6 and represents the value of the track axis corresponding to the front face of the i-th external teaching jig 17. An average value of $T_{x1}$ and $T_{x2}$ is supposed to be $T_{avg}$ (expression (3)). $\Delta\theta$ represents the inclination of the processing apparatus 14 with respect to the track axis and is obtained from an expression (4). An average value of $Z_{si}$ obtained in step 8 is supposed to be $S_{avg}$ (expression (2)). The wafer position Pos2 ($\theta_2$, $R_2$, $Z_2$, $T_2$) can be obtained from these values based on expressions (5) to (8).

[Expressions 1]

$$R_{avg} = (R_{x1} + R_{x2})/2 \qquad --- (1)$$

$$Z_{avg} = (Z_1 + Z_2)/2 \qquad --- (2)$$

$$T_{avg} = (T_{x1} + T_{x2})/2 \qquad --- (3)$$

$$\Delta\theta = \sin^{-1}((R_{x1} - R_{x2})/L_{pin}) \qquad ---- (4)$$

$$\theta_2 = 90° - \Delta\theta \qquad --- (5)$$

$$R_2 = R_{ofst} + R_{avg}/\cos \Delta\theta \qquad --- (6)$$

$$Z_2 = Z_{avg} + Z_{ofst} \qquad --- (7)$$

$$T_2 = T_{avg} - R_{avg} * \tan \Delta\theta \qquad --- (8)$$

In this manner, since the beforehand teaching position is corrected by Pos2, the path alongwhich the wafer gripper 5 approaches to the teaching jig 16 disposed inside the processing apparatus 14 in the conventional wafer teaching method can also be corrected, whereby the wafer gripper 5 can be prevented from interfering with the apparatus when the wafer gripper 5 passes the inlet opening 20.

Industrial Applicability

The invention is useful as a method of teaching the position of a semiconductor wafer to the semiconductor wafer transporting robot.

**Claims**

1. A wafer position teaching method for teaching a position of a semiconductor wafer to a robot that transports the semiconductor wafer between a housing chamber and a processing apparatus or between the processing apparatuses, the method comprising:

disposing a teaching jig at a position where the semiconductor wafer is disposed in the housing chamber or the processing apparatus;
detecting the teaching jig by a sensor provided at a wafer gripper of the robot;
detecting an external teaching jigs disposed at a front side outer wall of the processing apparatus to roughly estimate a position of the teaching jig by the sensor before detecting the teaching jig by the sensor;

approaching by the sensor to the teaching jig based on the estimated position; and
determining the position of the semiconductor wafer by sensing,

wherein the external teaching jigs comprise at least two external teaching jigs, and
the external teaching jigs are offset in a horizontal direction on the front side outer wall of the processing apparatus.

2. A teaching jig apparatus for teaching a position of a semiconductor wafer to a robot that transports the semiconductor wafer between a housing chamber and the processing apparatus or between the processing apparatuses, the teaching jig apparatus comprising:

external teaching jigs for performing preliminary detection; and
a teaching jig provided inside the processing apparatus,

wherein the external teaching jig comprise at least two external teaching jigs, and
the external teaching jigs are offset in a horizontal direction on a front side outer wall of the processing apparatus.

# FIG. 1

W

6

6

5

4

3

1

2

7

22

21

+ DIRECTION

TRACK AXIS

# FIG. 2

# FIG. 3

+ DIRECTION

R AXIS

## FIG. 4

+ DIRECTION

Z AXIS

θ AXIS

## FIG. 5

## FIG. 6

## FIG. 7

SIDE
VIEW

ELEVATIONAL
VIEW

## FIG. 8

SET TWO EXTERNAL TEACHING JIGS AT FRONT SIDE OUTER WALL OF APPARATUS — STEP 1

SINCE ATTACHMENT POSITIONS OF EXTERNAL TEACHING JIGS ARE KNOWN FROM INFORMATION SUCH AS DRAWING OF APPARATUS, WAFER GRIPPER IS MOVED TO SENSING START POSITION OF FIRST EXTERNAL TEACHING JIG
i = 1 — STEP 2

R-AXIS IS MOVED BACKWARD TO A POSITION WHERE SENSOR DOES NOT DETECT i-TH EXTERNAL TEACHING JIG — STEP 3

DIRECTION OF WAFER GRIPPER IS CHANGED BY θ-AXIS 5, THEN WAFER GRIPPER IS SLOWLY APPROACHED TO i-TH EXTERNAL TEACHING JIG BY R-AXIS, AND RECORD COORDINATES OF θ-AXIS AND R-AXIS OBTAINED WHEN SENSOR DETECTS i-TH EXTERNAL TEACHING JIG — STEP 4

STEP 5
NO ← STEPS 3 AND 4 ARE EXECUTED N TIMES ?
↓ YES

POSITION (θsi, Rsi) OF i-TH EXTERNAL TEACHING JIG IS OBTAINED AND RECORDED BY SOLVING LEAST SQUARE METHOD USING VALUES RECORDED IN STEP 4 — STEP 6

θ-AXIS IS OPERATED TO MOVE HAND SO AS TO BE ORTHOGONAL WITH RESPECT TO PROCESSING APPARATUS — STEP 7

SENSOR DETECTS UPPER SURFACE OF i-TH EXTERNAL TEACHING JIG WHILE MOVING WAFER GRIPPER UPWARD SLOWLY, THEREBY RECORDING VALUE OF Z-AXIS AS Zsi AT THIS TIME — STEP 8

i = 1 ? — NO
STEP 8-1 ↓ YES
STEP 8-2 — SET i = 2

ESTIMATE WAFER POSITION FROM VALUES STORED IN STEP 6 AND STEP 8 TO RECORD IN CONTROLLER — STEP 9

CONTINUE TO FIG. 9

# FIG. 9

CONTINUED FROM FIG. 8

COMPARISON IS MADE BETWEEN
ESTIMATED VALUE OBTAINED IN STEP 9 AND
BEFOREHAND TEACHING POSITION FOR EACH OF RESPECTIVE AXES,
AND DIFFERENCE THEREBETWEEN EXCEEDS
THRESHOLD VALUE ?

STEP 10

YES

NO

CONVENTIONAL AUTO-TEACHING OPERATION IS
PERFORMED TO OBTAIN WAFER TEACHING POSITION

STEP 11

STOP AUTO-TEACHING — STEP 12

# FIG. 10

## INTERNATIONAL SEARCH REPORT

| | International application No. |
|---|---|
| | PCT/JP2006/313027 |

A.  CLASSIFICATION OF SUBJECT MATTER
*B25J9/22*(2006.01)i, *B25J19/06*(2006.01)i, *B65G49/07*(2006.01)i, *H01L21/677*(2006.01)i

According to International Patent Classification (IPC) or to both national classification and IPC

B.  FIELDS SEARCHED

Minimum documentation searched (classification system followed by classification symbols)
B25J1/00-21/02, B65G49/07, H01L21/67-H01L21/687, G05B19/18-19/46

Documentation searched other than minimum documentation to the extent that such documents are included in the fields searched
Jitsuyo Shinan Koho          1922-1996   Jitsuyo Shinan Toroku Koho   1996-2006
Kokai Jitsuyo Shinan Koho    1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| A | JP 8-335622 A  (Tokyo Electron Ltd.),<br>17 December, 1996 (17.12.96),<br>Full text; all drawings<br>& US 6032083 A          & EP 836225 A1<br>& WO 1996/041371 A1 | 1,2 |
| A | WO 2003/022534 A1  (Yaskawa Electric Corp.),<br>20 March, 2003 (20.03.03),<br>Full text; all drawings<br>& US 2005/034288 A1 | 1,2 |
| P,X | JP 2005-310858 A  (Yaskawa Electric Corp.),<br>04 November, 2005 (04.11.05),<br>Abstract; Fig. 7<br>(Family: none) | 1,2 |

☐  Further documents are listed in the continuation of Box C.          ☐  See patent family annex.

| | |
|---|---|
| \*  Special categories of cited documents:<br>"A"  document defining the general state of the art which is not considered   to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    07 September, 2006 (07.09.06) | Date of mailing of the international search report<br>    19 September, 2006 (19.09.06) |
|---|---|
| Name and mailing address of the ISA/<br>    Japanese Patent Office | Authorized officer |
| Facsimile No. | Telephone No. |

Form PCT/ISA/210 (second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0322534 A
- JP 2005123261 A